Europäisches Patentamt

European Patent Office

Office européen des brevets

(19)

(11) Veröffentlichungsnummer: **0 252 222 B1**

# (12) EUROPÄISCHE PATENTSCHRIFT

(45) Veröffentlichungstag der Patentschrift: **13.03.91**

(51) Int. Cl.⁵: **B60R 21/00**, H01H 85/32, G01R 31/02

(21) Anmeldenummer: **87105346.8**

(22) Anmeldetag: **10.04.87**

(54) **Schaltung zur Spannungsversorgung eines elektrischen Bausteines.**

(30) Priorität: **27.06.86 DE 3621589**
**27.06.86 DE 3621590**

(43) Veröffentlichungstag der Anmeldung:
**13.01.88 Patentblatt 88/02**

(45) Bekanntmachung des Hinweises auf die
Patenterteilung:
**13.03.91 Patentblatt 91/11**

(84) Benannte Vertragsstaaten:
**DE ES FR GB IT SE**

(56) Entgegenhaltungen:
**DE-A- 3 116 867        FR-A- 2 030 318**
**FR-A- 2 309 121        GB-A- 2 177 515**
**US-A- 3 381 170        US-A- 4 359 715**

**IBM TECHNICAL DISCLOSURE BULLETIN,**
**Band 13, Nr. 1, Juni 1970, Seiten 59-60, New**
**York, US; H.E. LOWER: "Blown fuse sensor"**

(73) Patentinhaber: **AUDI AG**
**Auto-Union-Strasse 1 Postfach 220**
**W-8070 Ingolstadt(DE)**

(72) Erfinder: **Sterler, Georg, Dipl.-Ing.**
**Mozartstrasse 20**
**W-8071 Grossmehring(DE)**
Erfinder: **Bader, Heinz, Dipl.-Ing.**
**Adrian-v. Riedl-Strasse 3**
**W-8859 Karlshuld(DE)**

(74) Vertreter: **Le Vrang, Klaus**
**AUDI AG Postfach 220 Patentabteilung I/EQP**
**W-8070 Ingolstadt(DE)**

**Beschreibung**

Die Erfindung betrifft eine Schaltung zur Spannungsversorgung und Überprüfung eines in ein Kraftfahrzeug eingebauten elektrischen Bausteins gemäß Oberbegriff des Anspruchs 1.

Ein Beispiel für die Anwendung eines derartigen Bausteines ist die Auslöseschaltung für ein Airbag-System. Die Funktionsfähigkeit dieses Bausteines wird überwacht und ein Ausfall wird durch die Aktivierung eines Anschlusses, der eine Anzeigevorrichtung, wie beispielsweise eine Lampe ansteuert, angezeigt.

Die Spannungsversorgung des Bausteins erfolgt über einen abgesicherten Anschluß.

Nachteilig ist, daß bei Ausfall der Sicherung dem Fahrer kein Signal angegeben wird, das den Ausfall dieser sicherheitsrelevanten Baueinheit anzeigt. Auch die Prüflampe wird über die gleiche Sicherung versorgt und kann dementsprechend nicht aufleuchten.

Aufgabe der Erfindung ist es, eine gattungsgemäße Schaltung zu schaffen, bei der der Ausfall der Sicherung für die Stromversorgung des Bausteins durch die Prüflampe zur Kenntnis gebracht wird, und weiterhin der Spannungsausfall für Baustein und Prüflampe gemeinsam dem Fahrer mitgeteilt wird.

Die Aufgabe wird gelöst durch den Hauptanspruch.

Bevorzugte Ausführungen sind in den Unteransprüchen beschrieben.

Aus der französischen Patentschrift 2 232 830 ist es allgemein bekannt, den Ausfall von Sicherungen über eine Anzeigeeinheit zu signalisieren. Gegen den Ausfall des Stromes für die Signaleinrichtung wird jedoch keine Abhilfemaßnahme angeboten.

Im folgenden wird die Erfindung anhand der Figuren detailliert beschrieben. Es zeigen:

Fig. 1  die Schaltung gemäß Stand der Technik, und

Fig. 2  die Schaltung gemäß Erfindung, und

Fig. 3  eine weitere Schaltung gemäß Erfindung.

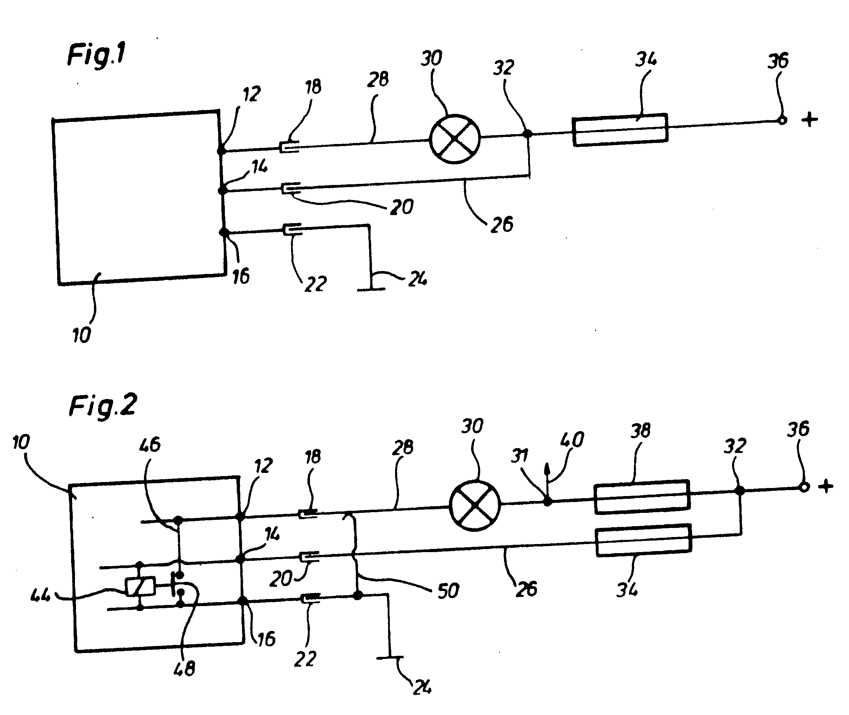

In Fig. 1 ist die Auslöseschaltung für ein Airbag-System, wie sie in heutigen Kraftfahrzeugen verbaut wird, dargestellt. Mit (10) ist die Auslöseschaltung selbst bezeichnet, die als Blockschaltung dargestellt ist, da das Innenleben dieser Schaltung für die vorliegende Erfindung nicht von Bedeutung ist.

Der Baustein (10) besitzt drei Anschlüsse (12, 14 und 16), wobei der Anschluß (14) für die positive Spannungsversorgung ausgelegt ist, während der Anspruch (16) der Masseanschluß ist. Der Anspruch (12) ist ein Fehleranzeigeanschluß, über den über eine Leitung (28) eine Prüflampe (30) angeschlossen ist. Selbstverständlich ist es möglich, statt einer optischen Anzeige (30) auch eine akustische Anzeige einzusetzen oder eine Sprachausgabeeinheit anzusteuern.

Die positive Spannungsversorgung (36) ist über eine Sicherung (34) und Leitung (26) an den positiven Versorgungsanschluß (14) des Bausteines (10) angeschlossen. Von dieser Verbindung zweigt im Punkt (32) die positive Spannungsversorgung der Lampe (30) ab.

Aus Gründen der besseren Auswechselbarkeit sind die Eingänge (12, 14 und 16) über Steckanschlüsse (18, 20 und 22) mit ihren Kabelzuführungen verbunden.

Wird nun bei der Fehlerüberwachung des Bausteines (10) ein Defekt festgestellt, wird der üblicherweise undefinierte oder auf Plus-Spannung liegende Anschluß (12) auf Masse gelegt, der sich dadurch ergebende Stromfluß von dem positiven Spannungspol (36) über die Sicherung (34), den Knotenpunkt (32) und die Lampe (30) zu dem auf Masse gelegten Pol (12) führt zu einem Aufleuchten der Lampe (30) und einer entsprechenden Anzeige.

Aus der Darstellung ist ohne weiteres zu erkennen, daß ein Ausfall der Sicherung (34) nicht durch Aufleuchten der Prüflampe (30) angezeigt wird. Der Benutzer des Fahrzeuges geht also weiterhin von einem intakten Airbag-System aus, während in Wirklichkeit das gesamte System inaktiviert ist durch den Ausfall der einfachen Sicherung (34).

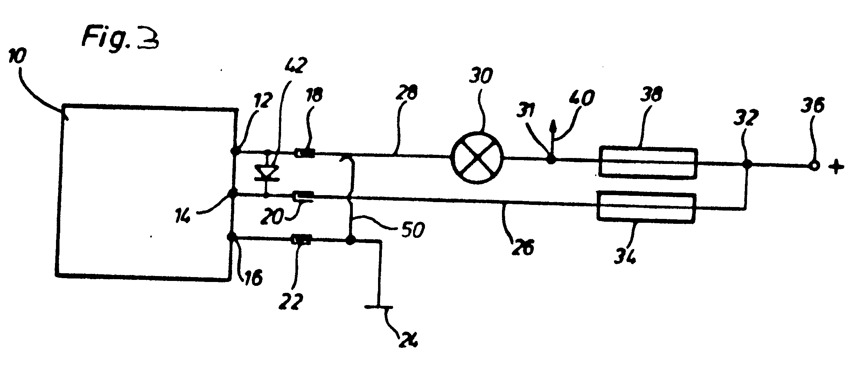

Die in Fig. 2 dargestellte erfindungsgemäße Schaltung löst dieses Problem.

Die in Fig. 1 und Fig. 2 gleichen Bauteile sind mit den gleichen Bezugszeichen bezeichnet, zur Vermeidung von Wiederholungen werden sie nicht nochmals erwähnt.

In der erfindungsgemäßen Schaltung liegt die Sicherung (34) nicht in dem gemeinsamen positiven Anschluß von Lampe (30) und Baustein (10), also plusseitig des Knotenpunktes (32), sondern sie liegt zwischen dem Knotenpunkt (32) und dem positiven Anschluß (14) des Bausteines (10), so daß die Lampe (30) nicht über die Sicherung (34) versorgt wird.

Die Lampe (30) ist plusseitig angeschlossen an einen Knotenpunkt (31), von dem eine weitere positive Spannung (40) weggeführt wird zu betriebsnotwendigen Teilen der Funktionseinheit, in die der Baustein (10) eingebaut ist. Im vorliegenden praktischen Fall wird über den Anschluß (40) die Zündung des Fahrzeuges versorgt, so daß ein Ausbleiben der Spannung im Punkt (31) zu einem sofortigen Liegenbleiben des Fahrzeuges führt. Es ist auch denkbar, über den Anschluß (40) andere Baugruppen, deren Ausfall sofort bemerkt wird, zu versorgen, z. B. einen elektronischen Tachometer. Zwischen den Knotenpunkten (31) und (32) ist eine Sicherung (38) vorgesehen, die somit die Zündung des Fahrzeuges absichert.

Anschluß (14) und Anschluß (16) sind, hier schematisch als Solenoid (44) eines Relais dargestellt, mit einer Ansteuereinheit verbunden, die eine Verbindungsleitung (46) zwischen Anschluß (12) und Anschluß (16) auftrennt - hier als Relaiskontakt (48) dargestellt, solange der Spannungswert der Versorgungsspannung im Punkt (14) einen unteren Grenzwert nicht unterschreitet. Unterhalb dieses Grenzwertes fällt der Anker (48) ab und stellt eine Stromverbindung vom Anschluß (12) zum Anschluß (16) her, wodurch der Anschluß (12) auf Masse gelegt wird.

In der Praxis ist die hier gewählte schematische Relaisdarstellung in Halbleitertechnik ausgeführt.

In der alternativen Ausführungsform nach Fig. 3 ist zwischen dem Anschluß (12) und dem Anschluß (14) des Bausteines (10) eine Diode (42) vorgesehen, deren Anode am Anschluß (12) und deren Katode am Anschluß (14) liegt.

Der Vollständigkeit halber ist ein Kurzschlußstecker (50) dargestellt, der bei geöffneten Steckkontakten (18, 20 und 22) dafür sorgt, daß die Leitung (28) unmittelbar auf Masse gelegt wird, wodurch bei geöffnetem Steckkontakt auch die Prüflampe (30) aufleuchtet.

Die Funktion der Schaltung nach Fig. 2 ist folgende:

Die Spannung des Bausteines (10) erfolgt im Normalbetrieb von dem Spannungspol (36) über den Knotenpunkt (32) und die Sicherung (34), Leitung (26) und Steckkontakt (20) zum Anschluß (14). Durch die korrekte Versorgungsspannung zieht das Relais (44) an und öffnet dabei den Kontakt (48). Wird ein Fehler im Baustein (10) erkannt, wird der Anschluß (12) auf Masse gelegt, wodurch die Lampe (30) über den Steckkontakt (18), die Leitung (28), den Knotenpunkt (31) und die Sicherung (38) zum Aufleuchten gebracht wird. Insoweit unterscheidet sich die Funktion der Schaltung nach Fig. 2 nicht von der Schaltung nach Fig. 1.

Wenn nun die Sicherung (34) nicht mehr durchgängig ist, zieht das Solenoid (44) den Anker nicht mehr an, die Kontakte (48) werden geschlossen und somit Anschluß (12) mit Anschluß (16) elektrisch verbunden. Der Anschluß (12) wird somit auf Massepotential gelegt. Dadurch fließt Stom zum Anschluß (12) vom positiven Spannungspol (36) über den Knotenpunkt (32), die Sicherung (38), den Knotenpunkt (31), die Lampe (30), die Leitung (28), und den Steckkontakt (18). Dadurch leuchtet die Lampe (30) auf und signalisiert einen Fehler in der Spannungsversorgung oder Überwachung des Bausteines (10).

In der Ausführungsform nach Fig. 3 fließt bei nicht mehr durchgängiger Sicherung (34) der Strom vom positiven Spannungspol (36) über den Knotenpunkt (32), die Sicherung (38) den Knotenpunkt (31), die Lampe (30), die Leitung (28), den Steckkontakt (18) und die Diode (42) zum Anschluß (14). Dieser der normalen Spannungsversorgung parallel geschaltete Kreis ist im Normalbetrieb aufgrund des hohen Widerstandes der Lampe (30) für die Stromversorgung vernachlässigbar, jedoch bei Ausfall der Sicherung (34) der einzig stromführende Weg für den Blockbaustein (10). Dadurch leuchtet die Lampe (30) auf und signalisiert einen Fehler in der Spannungsversorgung oder Überwachung des Bausteines (10).

Ein Ausfall der Sicherung (38), der dazu führen würde, daß die Lampe (30) ihre Anzeigefunktion verliert, bedeutet jedoch zugleich, daß über den Anschluß (40) keine Spannung mehr an weitere Teile des Kraftfahrzeuges geliefert wird. Wenn über die Leitung (40) Teile, wie beispielsweise die Benzinpumpe oder die Zündung versorgt werden, kann das Fahrzeug dementsprechend nicht mehr weiterbewegt werden nach Ausfall der Sicherung (38).

Selbstverständlich kann die Lampe (30) durch eine entsprechende Sicherheitslampe ersetzt werden, die bei Ausfall der Birne (30) auf eine andere Birne oder eine andere Einheit umschaltet. Die Darstellung der Anzeigeeinrichtung als Lampe ist auch nur beispielhaft zu verstehen.

Selbstverständlich kann die in der Erfindung vorgeschlagene Schaltung auch anderweitig eingesetzt werden, sie ist nicht auf den Anwendungsfall von Airbag-Systemen beschränkt.

## Ansprüche

1. Schaltung zur Spannungsversorgung und die Überprüfungsanzeige eines in eine Kraftfahrzeug eingebauten elektrischen Bausteins, vorzugsweise eine Auslöseschaltung für ein Airbag-System, mit einem Fehleranzeigeanschluß, der zur Aktivierung auf Masse gelegt wird, einer ersten Sicherung zur Absicherung des Versorgungsanschlusses, und einer Anzeigeeinheit, die bei Ausfallerkennung angesteuert wird und mit ihrem ersten Anschluß mit dem Fehleranzeigeanschluß verbunden ist und mit ihrem zweiten Anschluß auf Spannung gelegt ist, wobei der Fehleranzeigeanschluß bei Erkennen eines Fehlers oder bei Absinken der Versorgungsspannung unter einen unteren Grenzwert aktiviert wird, dadurch gekennzeichnet, daß die Spannungsversorgung des zweiten Anschlusses der Anzeigevorrichtung zugleich mit der Spannungsversorgung von betriebsnotwendigen elektrischen Teilen (Zündung) des Kraftfahrzeuges verbunden ist.

**2.** Schaltung nach Anspruch 1, dadurch gekennzeichnet, daß die Verbindungsstelle (31) des zweiten Anschlusses der Anzeigevorrichtung (30) mit der Spannungszuführung (40) zu den betriebsnotwendigen elektrischen Teilen der (Zündung) des Kraftfahrzeuges über eine weitere Sicherung (38) mit der Spannungsquelle (36) verbunden ist.

**3.** Schaltung nach Anspruch 1 oder 2, dadurch gekennzeichnet, daß der Fehleranzeigeranschluß (12) über eine Diode (42) in Durchlaßrichtung mit dem Versorgungsanschluß (14) des Bausteins (10) verbunden ist.

## Claims

**1.** Circuit for the voltage supply and the test display of an electrical assembly, preferably a trigger circuit for an air-bag system, installed in a motor vehicle, having an error display terminal which is connected for activation to earth, a first fuse for protecting the supply terminal and a display unit which is actuated in the event of detection of a failure and is connected by its first terminal to the error display terminal and to voltage by its second terminal, the error display terminal being activated in the event of the detection of an error or in the event of the dropping of the supply voltage below a lower threshold value, characterized in that the voltage supply of the second terminal of the display device is at the same time connected to the voltage supply of electrical components (ignition), necessary for operation, of the motor vehicle.

**2.** Circuit according to Claim 1, characterized in that the connection point (31) of the second terminal of the display device (30) to the voltage supply (40) to the electrical components (ignition), necessary for operation, of the motor vehicle is connected via a further fuse (38) to the voltage source (36).

**3.** Circuit according to Claim 1 or 2, characterized in that the error display terminal (12) is connected via a diode (42) in the conducting direction to the supply terminal (14) of the assembly (10).

## Revendications

**1.** Circuit pour l'alimentation en tension et l'indication de l'etat de fonctionnement d'un bloc ionctionnel électrique (10) incorpore dans un vèhicule automobile, de préférence un circuit de déclenchement pour un système de coussin pneumatique de sécurité, comportant une connexion de signalisation de défaut (12) qui est mise a la masse pour son activation, un premier coupe-circuit a fusible (34) pour la protection de la connexion d'alimentation (14) et une unité de signalisation (30) qui est activée en cas de détection de défaut, est raccordée a la connexion de signalisation de défaut (12) par sa première borne et est reliée à une source de tension (36) par sa seconde borne, la connexion de signalisation de défaut (12) étant activée en cas de détection d'un défaut ou en cas d'abaissement de la tension d'alimentation au-dessous d'une valeur limite inférieure, caractérisé en ce que l'alimentation en tension de la seconde borne du dispositif de signalisation (30) est raccordée en même temps (en 31) à l'alimentation en tension de parties électriques (allumage) du véhicule automobile nécessaires au fonctionnement de celui-ci.

**2.** Circuit selon la revendication 1, caractérisé en ce que le point de raccordement (31) de la seconde borne du dispositif de signalisation (30) a l'alimentation en tension (40) des parties électriques (allumage) du véhicule automobile nécessaires au fonctionnement de celui-ci est relié a la source de tension (36) par l'intermédiaire d'un autre coupe-circuit à fusible (38).

**3.** Circuit selon la revendication 1 ou 2, caractérisé en ce que la connexion de signalisation de défaut (12) est reliée a la connexion d'alimentation (14) du bloc fonctionnel (10) par l'intermédiaire d'une diode (42) dans le sens passant.

Fig.1

Fig.2

Fig. 3